# FASCICULE DE BREVET EUROPEEN

(11) **EP 2 732 406 B1**
(45) Date de publication et mention de la délivrance du brevet: **13.01.2016**
(21) Numéro de dépôt: 12758516.4
(22) Date de dépôt: 12.07.2012
(51) Int. Cl.: G06K 19/077

(54) **CARTE À CIRCUIT INTÉGRÉ HYBRIDE CONTACT - SANS CONTACT A TENUE RENFORCÉE DU MODULE ÉLECTRONIQUE**
HYBRIDKONTAKT-/KONTAKTLOSE CHIPKARTE MIT VERSTÄRKTEM ELEKTRONISCHEM MODUL
HYBRID CONTACT/CONTACTLESS INTEGRATED CIRCUIT CARD, THE STRENGTH OF THE ELECTRONIC MODULE OF WHICH IS REINFORCED

(30) Priorité: 12.07.2011 FR 1102195
(43) Date de publication de la demande: 21.05.2014
(73) Titulaire: ASK S.A., 06560 Valbonne (FR)
(72) Inventeur: BENATO, Pierre, F-06330 Roquefort les Pins (FR)
(86) Numéro de dépôt international: PCT/FR2012/000287
(87) Numéro de publication internationale: WO 2013/007897

(56) Documents cités:
- WO-A1-02/093472
- WO-A1-2008/058616
- GB-A- 2 380 068
- US-A1- 2004 159 709

## Description

### Domaine technique

La présente invention concerne les dispositifs d'identification radiofréquence (RFID) sans contact et concerne en particulier une carte à circuit intégré hybride contact - sans contact à tenue renforcée du module de circuit intégré et son procédé de fabrication.

### Etat de la technique

Un dispositif RFID sans contact est un dispositif constitué d'une antenne et d'un circuit intégré connecté aux bornes de l'antenne. Le circuit intégré n'est généralement pas alimenté et reçoit son énergie par couplage électromagnétique entre l'antenne du lecteur et l'antenne du dispositif RFID, des informations sont échangées entre le dispositif RFID et le lecteur et en particulier les informations stockées dans le circuit intégré qui ont trait à l'identification du possesseur de l'objet sur lequel se trouve le dispositif RFID et son autorisation à pénétrer dans une zone à accès contrôlé.

Une carte à circuit intégré hybride contact - sans contact est un dispositif RFID sans contact à la différence que l'échange des données avec le lecteur peut se faire également par contact sur des plages affleurantes et conductrices de la carte connectées au circuit intégré. Le circuit intégré est donc encapsulé dans un module dont la face externe comporte les plages de contacts affleurantes. Le circuit intégré est également connecté à la face interne du module destinée à venir se connecter à l'antenne de la carte. Ainsi, le circuit intégré est connecté aux deux faces d'un module double face de façon à former, une fois encapsulé, un module de circuit intégré double face ou module électronique double face. De ce fait, la tenue du module électronique et donc du circuit intégré sur la carte, est fragilisée par rapport à une carte à circuit intégré sans contact où le circuit intégré est le plus souvent noyé dans le corps de carte. Donc le problème majeur des cartes hybrides contact-sans contact est leur fragilité. En effet, le module est un élément rigide qui ne fléchit pas. Par conséquent, les contraintes sont concentrées autour du module en particulier le long de ses bords internes situés le plus près des axes de symétries de la carte donc du centre de la carte. Généralement, le procédé de fabrication des cartes à circuit intégré hybrides contact - sans contact comprend les étapes suivantes :
- une étape de fabrication de l'antenne sur un support,
- une étape de lamination des corps de carte sur le support de l'antenne consistant à souder de chaque côté du support une ou plusieurs feuilles en matière plastique, constituant les corps de carte, par pressage à chaud,
- une étape de fraisage des cavités consistant à percer, dans un des corps de carte, une cavité permettant de loger le module constitué par le circuit intégré et le circuit double face, la cavité comprenant une portion interne plus petite, recevant le circuit intégré et une portion externe plus grande recevant le module double face, le fraisage permettant de dégager les plots de connexion de l'antenne, et
- une étape d'insertion du module consistant à utiliser une colle permettant de fixer le module et une colle conductrice permettant de connecter le module aux plots de connexion, et à le positionner dans la cavité prévue à cet effet.

Les cartes à circuit intégré hybrides contact - sans contact sont soumises à des essais de flexion et torsion selon des critères définis dans la norme en vigueur. Un premier type de carte à circuit intégré hybride contact - sans contact est une carte monobloc dans laquelle le support d'antenne en matière plastique, est inséré entre deux couches en matière plastique constituant les corps de carte supérieur et inférieur et thermosoudés par lamination sous pression à chaud. Le module est connecté à l'antenne par une colle conductrice ou équivalent qui permet d'établir le contact ohmique.

Ce type de carte possède une grande rigidité d'ensemble. Par conséquent, lorsque ce type de carte est soumis à des contraintes mécaniques de flexion ou/et de torsion, les contraintes ne marquent pas la carte mais la carte casse le long des axes où les contraintes se manifestent le plus c'est-à-dire, le long du module.

Un autre type de carte est muni d'un support d'antenne en papier résistant à la cassure. Ce type de carte présente l'inconvénient de fournir une tenue fragile du module électronique sur la carte. En effet, un support d'antenne en matériau fibreux tel que du papier offre l'avantage de garder "en mémoire" les pliures de la carte, mais confère à la carte un manque de cohésion interne favorisant après de multiples pliures la délamination du papier sous les joints de colle tenant le module sur la carte et donc à la verticale de la partie la moins épaisse du corps de carte, provoquant par conséquent la déconnexion du module électronique et de l'antenne. En général, le premier contact du module qui se déconnecte de l'antenne est celui qui se situe le plus proche du centre de la carte. Le document WO 02/093472 divulgue une carte à puce qui comprend un support de puce en matériau fibreux de façon à ce que les contraintes de flexion et/ou torsion appliquées à la carte ne sont pas transmises à la connexion puce - antenne. L'inconvénient d'une telle carte réside dans la présence de deux couches de papier et des inconvénients de délamination qui en découlent comme mentionnés plus haut.

### Exposé de l'invention

C'est pourquoi le but de l'invention est de fournir une carte à circuit intégré hybride contact-sans contact qui remédie à ces inconvénients c'est-à-dire capable de résister à des essais de flexion sans que le corps de carte ne casse ou que la connexion entre le module et l'antenne ou l'antenne ne soit rompue.

L'objet de l'invention est donc une carte à puce hybride, contact-sans contact, comprenant un corps de carte constitué d'une pluralité de couches dont une des couches, dite couche de support supporte une antenne imprimée constituée d'au moins une spire et supporte un module de circuit intégré connecté à l'antenne par deux plots de connexion interne et externe situés respectivement dans le prolongement des extrémités interne et externe des spires d'antenne, le module étant situé sur la carte dans une portion délimitée par un premier côté de la carte, un second côté de la carte perpendiculaire au premier côté, une première ligne parallèle au premier côté de la carte et une seconde ligne parallèle au second côté de la carte. L'extrémité interne des spires d'antenne reliée au plot interne est située entièrement dans la portion de sorte que lorsque la carte est soumise à des contraintes de flexion ou/et torsion, la connexion entre le module et l'antenne n'est pas rompue. De plus, les plots de connexion sont réalisés par impression d'au moins deux couches d'une encre conductrice superposées l'une à l'autre sur le support, la première couche d'encre comprenant des espaces non recouverts d'encre.

### Description brève des figures

Les buts, objets et caractéristiques de l'invention apparaîtront plus clairement à la lecture de la description qui suit faite en référence aux dessins dans lesquels :
La figure 1 est une vue de dessus d'une carte à circuit intégré hybride contact-sans contact,
La figure 2 représente une coupe d'un module électronique double face selon l'état de la technique,
La figure 3 représente le module électronique double face selon l'état de la technique vu du côté du circuit intégré,
La figure 4 est une vue de dessus du support d'antenne de la carte à circuit intégré hybride contact-sans contact selon l'invention,
La figure 5 est une coupe des différentes couches constitutives de la carte selon l'invention,
La figure 6 représente une coupe de la carte selon l'invention muni de son module,
La figure 7 représente une vue de dessus en transparence du module et des plots de connexion de l'antenne selon l'invention.

### Description détaillée de l'invention

De façon générale dans la suite de la description, il est désigné par côté ou bord « interne » les bords et les côtés d'un élément situés géométriquement plus près du centre de la carte que les bords ou les côtés opposés du même élément désigné par « externe ».

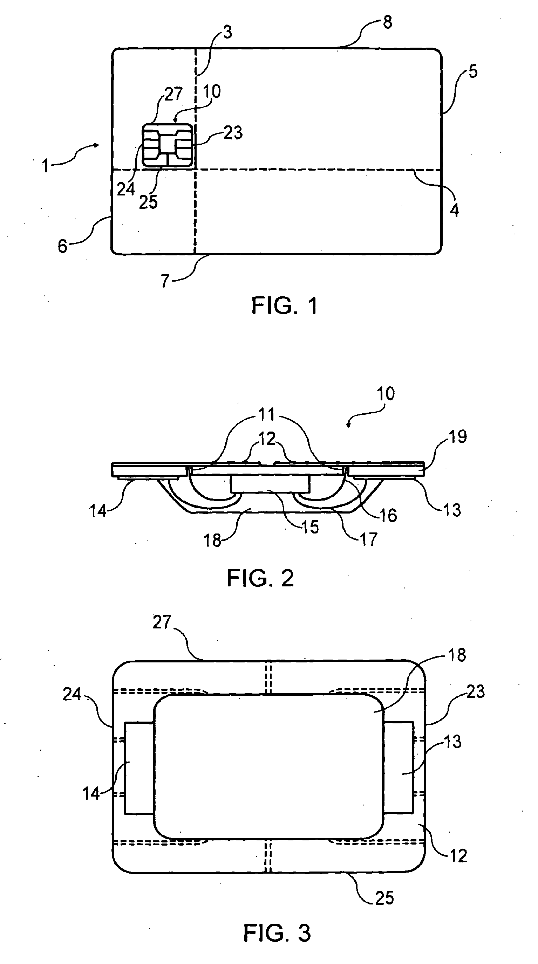

Selon l'illustration de la figure 1 une carte à circuit intégré hybride contact sans contact 1 est munie d'un module 10. Les dimensions extérieures de la carte correspondent au format « carte de crédit » définies dans la norme ISO 7810. La carte comprend deux petits côtés 5 et 6 perpendiculaires à deux grands côtés 7 et 8. Le module 10 comprend deux petits bords 23 et 24 et deux grands bords 25 et 27. Lors d'essais mécaniques et en particulier lors d'essais en flexion de la carte, les axes de la carte les plus sollicités c'est à dire où les contraintes sont les plus importantes sont représentés par les lignes en pointillés 3 et 4. Les lignes 3 et 4 situées le long des bords internes 23 et 25 du module sont respectivement parallèles aux côtés 6 et 8 de la carte. Les zones de rupture de la carte se situent sur ces lignes 3 et 4 à l'endroit du trait en continu le long des bords internes du module. Le module est situé sur la carte dans une portion délimitée par un premier côté 6 de la carte, un second côté 8 de la carte perpendiculaire au premier côté 6, la ligne 3 et la seconde ligne 4.

Selon la figure 2, le dispositif selon l'invention comprend un module électronique 10 constitué d'un support électriquement non conducteur 19 portant sur sa première face la plage des contacts affleurants 12 adaptés pour se connecter aux contacts de la tête de lecture du dispositif de lecture, et sur l'autre face, des contacts 13 et 14 adaptés pour être connectés à l'antenne de la carte. Un circuit intégré 15 est ensuite connectée à la fois à la plage de contacts affleurants 12 à l'aide de fils d'or soudés 16 traversant le support par des trous 11 prévus à cet effet et aux contacts 13 et 14 adaptés pour être connectés à l'antenne également par des fils d'or soudés 17. Le circuit intégré 15 et les fils 16 et 17 sont ensuite protégés et scellés par une résine 18 coulée par dessus. Lorsque la résine est durcie, le circuit intégré et les fils sont ainsi encapsulés et seule une partie des contacts 13 et 14 destinés à venir se connecter aux plots de l'antenne est apparente telle qu'illustrée sur la figure 3. Les contacts 13 et 14 du module 10 sont situés de part et d'autre de la résine 18 et sont parallèles respectivement aux petits bords 23 et 24 du module 10. Un tel module est appelé module de circuit intégré double face puisqu'il comprend des contacts sur ses deux faces contrairement à un module de circuit intégré simple face composé uniquement de la plage de contacts affleurants utilisé dans la réalisation des cartes à circuit intégré à contact. Le module est rigide de sorte qu'il ne fléchit pas lorsque la carte est soumise à des contraintes de flexion ou de torsion. Les connexions entre le circuit intégré 15 et les contacts 12, 13 et 14 sont ainsi protégés de toute cassure.

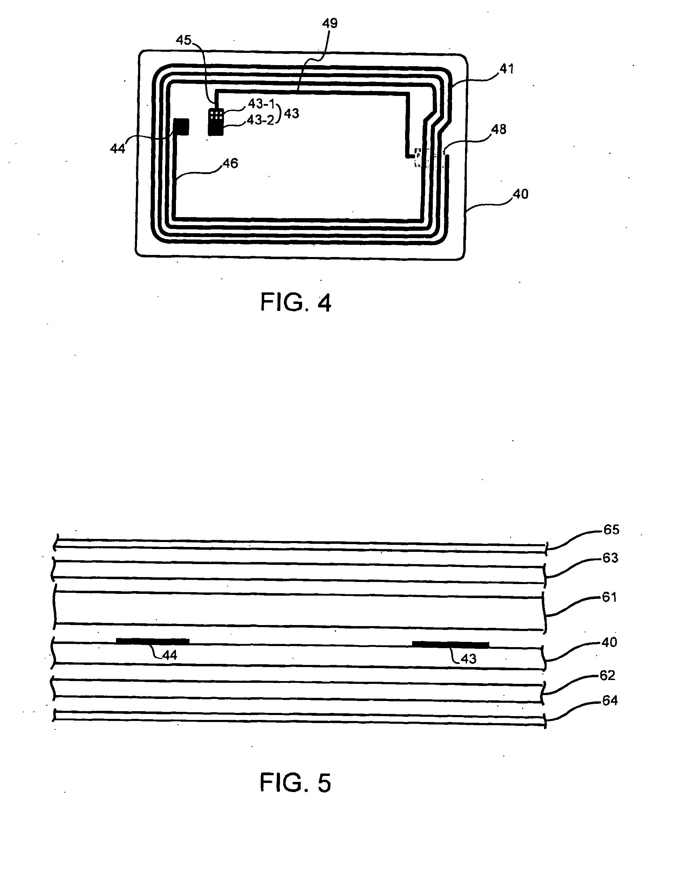

Selon la figure 4, une antenne 41 est réalisée sur une couche de support 40. L'antenne 41 est formée d'une pluralité de spires d'un matériau électriquement conducteur. Les spires de forme sensiblement rectangulaires comportent plusieurs portions droites de façon à longer les bords de la carte. Les spires d'antenne se croisent au niveau d'un pont isolant 48. Les spires se terminent par deux extrémités 45 et 46 formant deux portions droites d'antenne prolongées respectivement par deux plots de connexion 43 et 44 destinés à être connectés électriquement aux deux contacts 13 et 14 du module. Les deux extrémités 45 et 46 des spires d'antenne sont appelés respectivement extrémités interne et extrémité externe. Les spires et les plots de connexion de l'antenne sont réalisés par impression de type sérigraphie, flexographie, héliogravure, offset ou jet d'encre à partir d'encre conductrice de type encre époxy chargée de particules conductrices telles que par exemple d'argent ou d'or ou à partir d'un polymère conducteur. La couche de support 40 est de préférence dans un matériau qui ne flue pas (c'est à dire qui ne se déforme pas sous l'effet de la température) tel que du papier ou du papier synthétique (type teslin).

L'extrémité interne 45 des spires d'antennes est située sur le support de façon à ne pas couper la ligne 3. Ainsi, la portion de spire 49 qui prolonge l'extrémité 45 coupe la ligne 3 en étant le plus éloignée possible du bord interne 23 du module. Cette configuration éloigne le plus possible l'extrémité 45 de la zone de rupture. L'intersection de la portion de spire 49 et de la ligne 3 doit donc se situer au plus près du bord de la carte en tenant compte de l'emplacement des autres spires d'antenne. Le plot de connexion interne 43 situé le plus près du centre de la carte est le plus sollicité mécaniquement lorsque la carte est soumise à des essais en flexion autour de l'axe de symétrie transversale de la carte. Le plot de connexion externe 44 situé près du bord 6 de la carte subit peu de contraintes mécaniques. Selon l'invention, les deux plots de connexion 43 et 44 sont fabriqués par impression d'au moins deux couches d'encre sur le support d'antenne 40. Les couches d'encre constitutives du plot de connexion externe 44 se superposent les unes aux autres et ont toutes la même forme et les mêmes dimensions. Les dimensions du plot 44 sont telles que sa surface interne englobe largement la surface du contact 14 du module 10. Plus précisément, la surface du plot 44 est au moins égale à deux fois la surface du contact 14 du module 10. Les couches d'encre constitutives du plot 43 désignées par couche 43-1 et 43-2 se superposent les unes aux autres et elles n'ont pas toutes les mêmes dimensions. La surface de la première couche d'encre 43-1 du plot 43 est plus grande que la surface des couches d'encre successives. La seconde couche et les couches suivantes de la première couche 43-1 constitutive dudit plot 43 ont la même superficie que la surface des couches constitutives du plot de connexion 44. La première couche d'encre 43-1 du plot de connexion 43 est ajourée. Selon le mode de réalisation préféré de l'invention, la couche d'encre 43-1 est réalisée sous forme d'un maillage dont les mailles présentent des espaces 47 où il n'y a pas d'encre. Ces espaces peuvent être de différentes formes sans que cela sorte du cadre de l'invention. Cette configuration de la première couche permet d'accrocher davantage la seconde couche au support par collage d'une partie de l'encre de la seconde couche directement sur le support d'antenne à travers les espaces 47 de la première couche de façon à éviter que les couches d'encre constitutives du plot de connexion se délaminent. La superficie de la seconde couche d'encre 43-2 est inférieure à celle de la couche d'encre 43-1 et est égale aux surfaces des couches d'encre du plot 44. Une fois toutes les couches d'encre superposées, l'épaisseur d'encre des plots d'antenne est comprise entre 50 et 80 µm.

La carte selon l'invention comprend une pluralité de couches illustrée en coupe sur la figure 5. La figure n'étant pas à l'échelle, seuls les deux plots de connexion 43 et 44 sont représentés. Sur la couche de support d'antenne 40 et plus précisément sur la face de la couche 40 où est réalisée l'antenne, sont disposées dans cet ordre une couche de polychlorure de vinyle (PVC) 61, une couche de polyesters (PET) 63 et une couche de couverture 65. Sur l'autre face de la couche de support d'antenne 40, sont disposées dans cet ordre une couche de PET 72 et une couche de couverture 64.

L'étape de lamination consiste à empiler l'ensemble des couches 40, 61, 63, 65, 62 et 64 et à lui faire subir un traitement thermique à une température de l'ordre de 150°C sous une pression de l'ordre de 20 Bars. Sous l'effet de la pression et de la température la couche de PVC 61 se ramollit et vient englober les spires d'antennes et les plots d'antenne 43 et 44. Les deux couches de PET rigidifie l'ensemble et en particulier la couche de PET 62 non percée de la cavité dans laquelle vient se loger le module. Cette configuration de couches constitutives de la carte présente l'avantage de conférer à la fois de la résistance et de la souplesse à la carte de façon à ce que la carte ne casse plus pendant les essais de flexion et/ou de torsion.

L'étape suivante consiste à fraiser une cavité destinée à recevoir le module 10 et à coller le module dans la cavité.

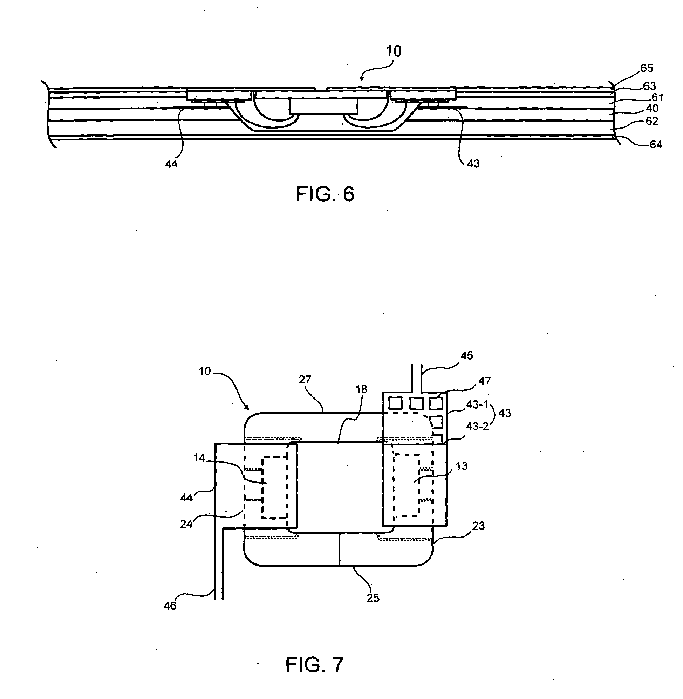

Par transparence sur la figure 7, on peut voir le module 10 lorsqu'il est dans la position connectée aux plots d'antenne. Les plots 43 et 44 se superposent aux contacts 13 et 14 du module 10. Les extrémités 45 et 46 des spires d'antenne sont parallèles aux petits côtés 23 et 24 du module et perpendiculaires aux grands côtés 25 et 27 du module. Par conséquent, les extrémités 45 et 46 des spires d'antenne ne coupent pas la zone de rupture de la carte c'est-à-dire la zone où les contraintes de flexion sont maximum. Si on prolonge l'extrémité 45 des spires d'antenne dans leur axe, (selon la figure et le mode de réalisation décrit cet axe est une ligne droite), elle traverserait la surface délimitée par le module. L'axe de l'extrémité 45 et le plot de connexion 43 sont configurés de telle façon qu'ils croisent le module 10 en coupant son grand bord externe 27.

Cette configuration de l'extrémité des spires d'antenne permet d'éloigner l'antenne de la zone de rupture située le long du bord 23 du module. De plus, l'extrémité 45 se situe dans le prolongement de la partie du plot de connexion interne 43 située à l'intérieur du module. De cette façon, l'extrémité 45 des spires d'antenne ne risque pas d'être coupée lorsque la carte subit des contraintes mécaniques de flexion.

Le plot 44 déborde du module du côté de son petit bord externe 24. La surface de la première couche d'encre 43-1 déborde du module du côté de son bord interne 23 et de son grand bord externe 27.

## Revendications

1. Carte à puce (1) hybride, contact - sans contact, comprenant un corps de carte constitué d'une pluralité de couches dont une des couches, dite couche de support (40) supporte une antenne imprimée (41) constituée d'au moins une spire et supporte un module de circuit intégré (10) connecté à ladite antenne par deux plots de connexion interne et externe (43, 44) situés respectivement dans le prolongement des extrémités interne et externe (45, 46) des spires d'antenne, ledit module étant situé sur la carte dans une portion délimitée par un premier côté (6) de la carte, un second côté (8) de la carte perpendiculaire audit premier côté, une première ligne (3) parallèle audit premier côté (6) de la carte et une seconde ligne (4) parallèle audit second côté de la carte,
ladite extrémité interne (45) des spires d'antenne reliée audit plot interne (43) est située entièrement dans ladite portion de sorte que lorsque la carte est soumise à des contraintes de flexion ou/et torsion la connexion entre le module et l'antenne n'est pas rompue et
**caractérisée en ce que** lesdits plots de connexion (43, 44) sont réalisés par impression d'au moins deux couches d'une encre conductrice superposées l'une à l'autre sur ledit support (40), la première couche d'encre (43-1) comprenant des espaces (47) non recouverts d'encre.

2. Carte selon la revendication 1, dans laquelle le prolongement (49) de ladite extrémité (45) croise ladite ligne (3), ladite extrémité (45) croise ledit axe (3) et leur intersection se situe le plus éloignée possible sur la carte dudit bord interne (23) dudit module (10).

3. Carte selon la revendication 1 ou 2, dans laquelle ladite extrémité (45) se situe dans le prolongement de la partie dudit plot de connexion interne (43) située à l'intérieur du module.

4. Carte selon l'une des revendications 1, 2 ou 3, dans laquelle la seconde couche et les couches suivantes de la première couche (43-1) constitutive dudit plot (43) ont la même surface que la surface des couches constitutives dudit plot de connexion (44).

5. Carte selon l'une des revendications précédentes, dans laquelle l'épaisseur desdits plots de connexion (43, 44) est comprise entre 50 µm et 80 µm.

6. Carte selon la revendication précédente, dans laquelle ladite antenne (41) et ledit module (10) sont noyés dans le polychlorure de vinyle (PVC) (61) de la couche du corps de carte située sur la première face de ladite couche de support (40), la première face étant celle sur laquelle ladite antenne est imprimée.

7. Carte selon la revendication 6, dans laquelle la seconde face de la couche de support (40) est recouverte d'une couche de polyesters (PET) (62).

8. Carte selon l'une des revendications précédentes dans laquelle ladite couche de PVC (61) est recouverte d'une couche de PET (63).

## Patentansprüche

1. Hybridkontakt/-kontaktlose Chipkarte (1), umfassend einen Kartenkörper, der von einer Vielzahl von Schichten gebildet ist, eine der Schichten, Tragschicht (40) genannt, eine gedruckte Antenne (41) von denen trägt, die aus mindestens einer Windung besteht und ein Modul einer integrierten Schaltung (10) trägt, das an die Antenne durch zwei innere und äußere Anschlussstücke (43, 44) angeschlossen ist, die sich jeweils in der Verlängerung der inneren und äußeren Enden (45, 46) der Antennenwindungen befinden, wobei das Modul auf der Karte in einem Abschnitt angeordnet ist, der von einer ersten Seite (6) der Karte, einer zweiten Seite (8) der Karte senkrecht auf die erste Seite, einer ersten Linie (3) parallel zur ersten Seite (6) der Karte und einer zweiten Linie (4) parallel zur zweiten Seite der Karte begrenzt ist,
wobei das innere Ende (45) der Antennenwindungen, das mit dem inneren Anschlussstück (43) verbunden ist, zur Gänze in dem Abschnitt angeordnet ist, so dass, wenn die Karte Biege- und/oder Torsionsspannungen ausgesetzt ist, der Anschluss zwischen dem Modul und der Antenne nicht unterbrochen wird, **dadurch gekennzeichnet, dass** die Anschlussstücke (43, 44) durch Drucken von mindestens zwei Schichten einer leitfähigen Farbe, die übereinander auf dem Träger (40) angeordnet sind, hergestellt sind, wobei die erste Farbschicht (43-1) nicht mit Farbe bedeckte Räume (47) umfasst.

2. Karte nach Anspruch 1, bei der die Verlängerung (49) des Endes (45) die Linie (3) kreuzt, das Ende (45) die Achse (3) kreuzt, und sich der Schnittpunkt auf der Karte möglichst weit entfernt vom inneren Rand (23) des Moduls (10) befindet.

3. Karte nach Anspruch 1 oder 2, bei der sich das Ende (45) in der Verlängerung des Teils des inneren Anechlussstücks (43), das im Inneren des Moduls angeordnet ist, befindet.

4. Karte nach einem der Ansprüche 1, 2 oder 3, bei der die zweite Schicht und die folgenden Schichten der ersten Schicht (43-1), die das Anschlussstück (43) bilden, dieselbe Oberfläche wie die Oberfläche der Schichten haben, die das Anschlussstück (44) bilden.

5. Karte nach einem der vorhergehenden Ansprüche, bei der die Dicke der Anschlussstücke (43, 44) zwischen 50 µm und 80 µm beträgt.

6. Karte nach dem vorhergehenden Anspruch, bei der die Antenne (41) und das Modul (10) in Polyvinylchlorid (PVC) (61) der Schicht des Kartenkörpers eingelassen sind, die sich auf der ersten Seite der Trageschicht (40) befindet, wobei die erste Seite jene ist, auf die die Antenne gedruckt ist.

7. Karte nach Anspruch 6, bei der die zweite Seite der Trageschicht (40) mit einer Polyesterschicht (PET) (62) bedeckt ist.

8. Karte nach einem der vorhergehenden Ansprüche, bei der die PVC-Schicht (61) mit einer PET-Schicht (63) bedeckt ist.

## Claims

1. A hybrid contact-contactless smart card (1) comprising a card body made up of a plurality of layers, one of the layers of which, referred to as the supporting layer (40), supports a printed antenna (41) made up of at least one turn and supports an integrated circuit module (10) connected to said antenna by two internal and external contacts (43, 44) located in the continuation of the internal and external extremities (45, 46), respectively, of the antenna turns, said module being located on the card in a portion defined by a first side (6) of the card, and a second side (6) of the card perpendicular to the first side, a first line (3) parallel to said first side (6) of the card and a second line (4) parallel to said second side of the card,
**characterised in that** said internal end (45) of the antenna turns connected to said internal contact (43) is located entirely in said portion in such a way that when the card is subjected to bending and/or twisting stresses, the connection between the module and the antenna is not broken and **characterised in that** said contacts (43, 44) are made by printing of at least two layers of an electrically conductive ink overlapped each other onto said support (40), the fist layer of ink (43-1) including spaces (47) not covered with ink.

2. The card according to claim 1, wherein the continuation (49) of said end (45) crosses said line (3), said end (45) crosses said axis (3) and their intersection is located as far away as possible on the card of said internal edge (23) of said module (10).

3. The card according to claim 1 or 2, wherein said end (45) is located in the continuation of the part of said internal contact (43) located inside the module.

4. The card according to any of claims 1 through 3, wherein the second and following layers of the first component layer (43-1) of said contact (43) have the same surface area as that of the component layers of said contact (44).

5. The card according to any one of previous claims, wherein the thickness of said contacts (43, 44) is between 50 *µ*m and 8 *µ*m.

6. The card according to the previous claim, wherein said antenna (41) and said module (10) are encased in the polyvinyl chloride (PVC) (61) of the layer of the card body located on the first face of said supporting layer (40), the first face being that on which said antenna is printed.

7. The card according to claim 6, wherein the second face of the supporting layer (40) is covered by a layer of polyesters (PET) (62).

8. The card according to any one of previous claims, wherein said layer of PVC (61) is covered by a layer of PET (63).
